# EUROPÄISCHE PATENTANMELDUNG

(11) **EP 1 286 385 A2**
(43) Veröffentlichungstag der Anmeldung: **26.02.2003**
(21) Anmeldenummer: 02017091.6
(22) Anmeldetag: 29.07.2002
(51) Int. Cl.: H01L 21/00

(54) **Vorrichtung zum Debonden von Dünnwafern**

(30) Priorität: 21.08.2001 DE 10140827
(71) Anmelder: Infineon Technologies AG, 81669 München (DE)
(72) Erfinder: Kalin, Thomas, 9500 Villach (AT); Unterweger, Josef, 9520 Annenheim (AT); Matschitsch, Martin, 9181 Freistritz i. Ros (AT)
(74) Vertreter: Kindermann, Peter, Dipl.-Ing.

(57) **Zusammenfassung**

Eine Debondierstation (6) zum Trennen von miteinander mittels einer Adhesiv-Schicht (3) zu Waferstacks (1) verbundenen Systemwafern (4) und Trägerwafern (2) weist eine Trennstation (12) auf, mittels der die Adhäsionskraft der Adhesiv-Schicht (3) thermisch soweit aufgehoben wird, dass ein Roboter (10) den dünnen Systemwafer (4) vom Trägerwafer (2) lösen kann, ohne dass der Systemwafer (4) beschädigt wird. Anschließend wird durch eine Folienabziehvorrichtung (15) der Trägerwafer (2) aufbereitet, so dass er wieder mit einem Systemwafer (4) bestückt werden kann.

## Beschreibung

Die Erfindung bezieht sich auf eine Vorrichtung zum Debonden von Dünnwafern gemäß dem Oberbegriff des Anspruches 1.

In der Dünnwafer-Produktion werden dünne und damit mechanisch unstabile, d. h. sensible Wafer mittels einer Adhesiv-Schicht (z. B. Lack, Temperaturfolien, Wachs) auf stabile Trägerwafer montiert und bilden dadurch einen stabilen, sogenannten Waferstack. Damit können dünne Wafer wie stabile, dickere Wafer automatisch mit Standard-Vorrichtungen gehandhabt werden. Die Waferstacks bestehen also aus dem dünnen Systemwafer, auf welchem die Halbleiter gebildet werden und aus dem Trägerwafer, welcher zur mechanischen Stützung des Systemwafers dient. Diese Waferstacks werden zu mehreren in Kassetten abgelegt und diese Kassetten werden mit sogenannten Handlingvorrichtungen in den Prozessabläufen gehandhabt. Zur Bearbeitung von Wafern sind Anlagen erforderlich, die eine Vielzahl von Fertigungseinheiten und Vorrichtungen umfassen. Einer dieser vielen Prozessschritte ist das Debonden der Waferstacks, ein Arbeitsprozess, bei welchem die dünnen Systemwafer wieder von den Trägerwafern getrennt werden. Dies geschieht nach dem Stand der Technik manuell, was einen sehr hohen Personalaufwand erfordert und mit sehr viel Ausschuss durch eine hohe Waferbruchrate verbunden ist, da die Systemwafer des hier abgehandelten Typs nur sehr dünn, beispielsweise 70µm dick sind. Die manuelle Durchführung der einzelnen Arbeitsabläufe führt zwangsläufig zu unterschiedlichen Prozessergebnissen und die Reproduzierbarkeit der Arbeitsabläufe ist nicht konstant.

Der Erfindung liegt die Aufgabe zugrunde, eine Vorrichtung zum Debonden - also zum Trennen - von Systemwafern und Trägerwafern anzugeben, bei welcher die Durchführung der Arbeitsabläufe reproduzierbar und die Waferbruchrate gering ist, und bei der die Prozessergebnisse gleichmäßig sind.

Diese Aufgabe wird durch eine Vorrichtung mit den Merkmalen des Anspruches 1 gelöst, vorteilhafte Ausgestaltungen der Erfindung sind den abhängigen Ansprüchen zu entnehmen.

Die Vorteile der Erfindung liegen in dem automatischen Ablauf der Arbeitsschritte ohne zusätzlichen Personalaufwand, in der hohen Reproduzierbarkeit, in dem sicheren Handling der Dünnwafer durch die speziellen Halterungen und in dem zuverlässigen Ablösen des Systemwafers von dem Trägerwafer durch den selbsttätigen Bewegungsablauf.

Mit Hilfe eines Ausführungsbeispiels wird die Erfindung nachstehend anhand der Zeichnungen noch näher erläutert.

Es zeigt:
Figur 1 ein Waferstack, stark schematisiert;
Figur 2 eine Kassette zur Aufnahme eines Waferstacks;
Figur 3 eine Station zum automatischen Trennen von Waferstacks;
Figur 4 eine einzelne Vorrichtung aus Figur 3 zum Trennen von Waferstacks.

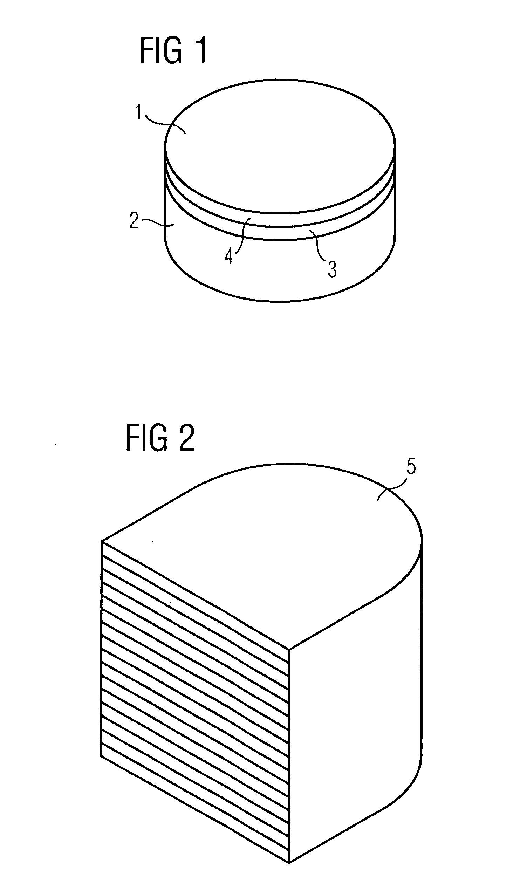

In Figur 1 ist stark schematisiert ein Waferstack 1 dargestellt. Ein solcher Waferstack 1 besteht aus einem Trägerwafer 2, auf dem mittels einer Adhesiv-Schicht 3 ein Systemwafer 4 aufgebracht ist. Der Systemwafer 4 ist der Träger für die herzustellenden Halbleiter und muss zu deren Herstellung eine Reihe von Fertigungsschritten, sogenannten Prozessschritten durchlaufen. Die Forderung nach immer geringeren Abmessungen bei elektronischen Geräten verlangt nach größerer Packungsdichte und kleineren Abmessungen bei Halbleitern und erfordert immer dünnere Systemwafer 4, die es zu prozessieren gilt. Der derzeitige Stand der Technik erlaubt Waferdicken von ca. 70µm, was aber zu großen Problemen bei der Handhabung dieser dünnen Systemwafer 4 führt. Damit derartig dünne Waferscheiben in den Prozessschritten oder beim Wechsel von einem Prozess zum nächsten nicht zerstört werden, werden sie auf sogenannte Trägerwafer 2 montiert und mit diesen zusammen in Kassetten 5 angeordnet. Diese mit Waferstacks 1 angefüllten Kassetten 5 durchlaufen anschließend die unterschiedlichsten Fertigungsvorgänge - die Prozessschritte -, die zur Herstellung der Halbleiter erforderlich sind. Im Anschluss an die einzelnen Fertigungsschritte müssen die Waferstacks 1 wieder aufgelöst werden, d. h., die Systemwafer 4 müssen von den Trägerwafern 2 gelöst werden, um anschließend weiter verarbeitet zu werden. Die Weiterverarbeitung der Systemwafer 4 kann dabei das Zerschneiden in die einzelnen Halbleiterschaltungen sein und wird hier nicht weiter behandelt. Die Trägerwafer 2 müssen anschließend neue Systemwafer 4 aufnehmen, damit diese neu zusammengestellten Waferstacks 1 in den Fertigungsablauf gelangen können. Um neue Systemwafer 4 aufnehmen zu können, müssen die alten Adhesiv-Schichten 3 sauber und restlos von den Trägerwafern 2 gelöst werden, damit mittels neuer Adhesiv-Schichten 3 neue Systemwafer 4 sauber und exakt auf den Trägerwafern 2 montiert werden können. Dieses Ablösen der fertigen Systemwafer 4 von den Trägerwafern 2 und das saubere und rückstandsfreie Beseitigen der verbrauchten Adhesiv-Schichten 3 nennt man "Debonden" oder "Debondieren". Wie eingangs geschildert, wird dieses Debondieren gemäß dem Stand der Technik manuell durchgeführt, was zu den vorbeschriebenen Nachteilen führt.

In Figur 2 ist schematisch eine Kassette 5 zur Aufnahme von Waferstacks 1 dargestellt, wie sie in Figur 1 gezeigt und kurz beschrieben sind. Eine Kassette 5 weist hier in der Zeichnung nur angedeutete Schlitze bzw. Ausnehmungen zur Aufbewahrung von Waferstacks 1 auf, in welche die Waferstacks 1 eingeschoben werden.

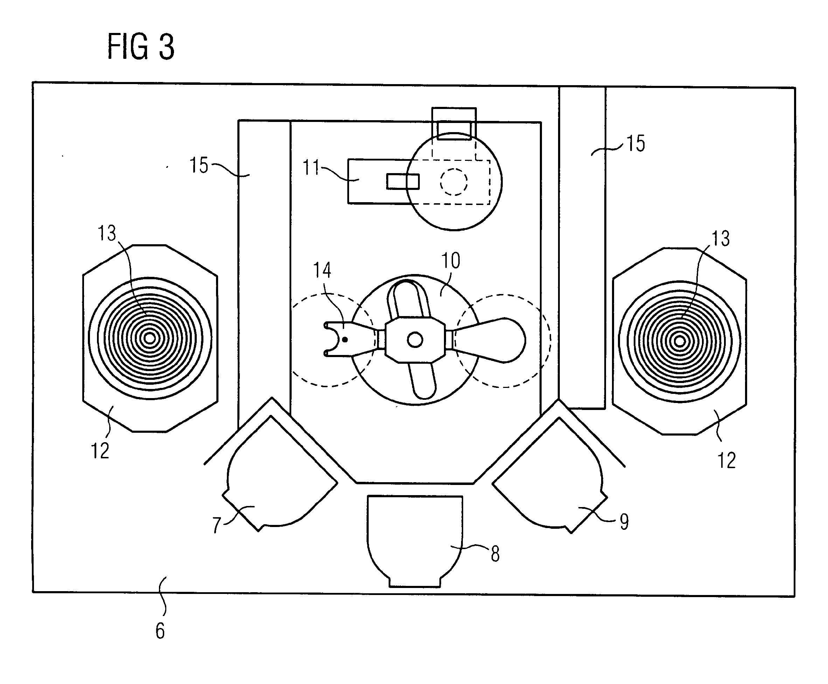

In Figur 3 sind die für die Erfindung wesentlichen Elemente einer sogenannten Debondstation 6 zum automatischen Debondieren, also zum Trennen von Waferstacks 1 gezeigt. Die zu Waferstacks 1 montierten Trägerwafer 2 und Systemwafer 4, welche nach dem Durchlaufen ihrer Prozessschritte zumindest in einem Fertigungsabschnitt fertig gestellt sind, müssen wieder vom einander getrennt werden. Dazu muss der Systemwafer 4 vom Trägerwafer 2 gelöst werden. Für die Prozessdurchläufe waren die einzelnen Systemwafer 4 mittels Adhesiv-Schicht 3 auf Trägerwafern 2 montiert und in Aufbewahrungsstationen wie Magazinen, Kassetten 5 oder dergleichen deponiert, mit denen sie die verschiedenen Fertigungsprozesse durchlaufen haben. In allgemeiner Form können diese Aufbewahrungsstationen als Waferstack- Aufbewahrungsstation7, als Systemwafer- Aufnahmestation 8 und als Trägerwafer- Aufnahmestation 9 bezeichnet werden.

Die hier beschriebene Debondstation 6 besteht in ihren hier relevanten Bestandteilen aus wenigstens drei Kassettenstationen 7, 8 und 9, einem Handhabungsautomaten (Roboter 10), einer Lesestation 11 sowie der eigentlichen Trennstation 12, in welcher die Waferstacks 1 debondiert, also die Systemwafer 4 von den Trägerwafern 2 getrennt werden. Die Kassettenstationen 7, 8, 9 bestehen aus der Waferstack- Aufbewahrungsstation 7, in der die vollständigen Waferstacks 1 deponiert sind, und aus der Systemwafer- Aufnahmestation 8 für die Systemwafer 4 und einer zweiten, mit dem Bezugszeichen 9 versehenen Trägerwafer- Aufnahmestation 9 für die Trägerwafer 4. Der Roboter 10 entnimmt aus der Waferstack- Aufbewahrungsstation 7 der entsprechenden Kassette 5 einen Waferstack 1, bereitet ihn für die Lesestation 11 vor, in welcher er registriert wird, und befördert anschließend den zu trennenden Waferstack 1 zur Trennstation 12, in welcher er zum Debondieren abgelegt wird.

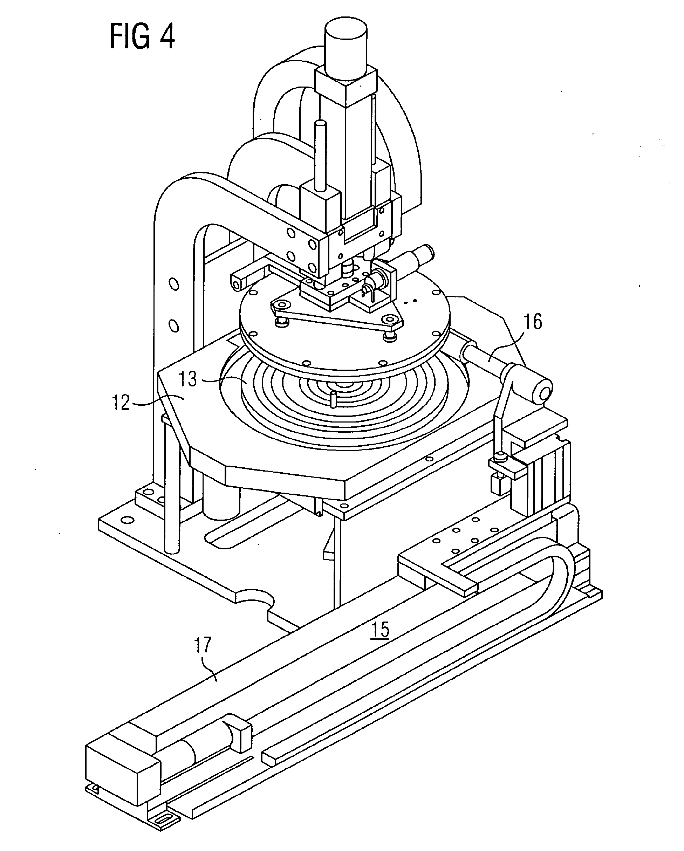

Die Trennstation 12, welche in Figur 4 genauer dargestellt ist, weist eine Heizvorrichtung 13 auf, in die eine Aufnahmevorrichtung zur Aufnahme des Waferstacks 1 integriert ist. Diese Aufnahmevorrichtung ist als sogenannter Vakuumchuck ausgebildet, d. h., er hält den Waferstack 1 mittels Unterdruck in der geforderten Position. Die Heizvorrichtung 13, heizt den vom Vakuumchuck gehaltenen Waferstack 1 derart auf, dass die thermisch beeinflussbare Adhesiv-Schicht 3 zumindest soweit an Adhäsionskraft verliert, dass der Systemwafer 4 mittels eines sogenannten Endeffektors 14 des Roboters 10 von dem Trägerwafer 2 abgehoben werden kann. Der Endeffektor 14 ist ebenfalls als Vakuumchuck ausgebildet, was bedeutet, dass er eine an sich bekannte und deshalb hier nicht näher bezeichnete Vorrichtung enthält, welche mittels Unterdruck den dünnen Systemwafer 4 vorsichtig anheben und von dem Trägerwafer 2 lösen kann.

Der Systemwafer 4 wird anschließend von dem Endeffektor 14 in der Systemwafer- Aufnahmestation 8 für die Systemwafer 4 abgelegt. Der Trägerwafer 2 weist nach dem Lösen des Systemwafers 4 in der Regel noch Reste der Adhesiv-Schicht 3 auf, die eine erneute Verwendung dieses Trägerwafers 2 verhindern. Der Trägerwafer 2 muss also zur erneuten Verwendung wieder aufbereitet werden. Dazu dient eine Aufbereitungsvorrichtung 15, welche zum Entfernen der restlichen Adhesiv-Schicht als Folienabziehvorrichtung 15 ausgebildet und in der Trennstation 12 vorhanden ist. Diese Folienabziehvorrichtung 15 weist eine Kontaktrolle 16 auf, die rotierend über den Trägerwafer 2 geführt wird, und dabei die Adhesiv-Schicht 3 sauber und rückstandsfrei vom Trägerwafer 2 durch Abziehen löst. Die in Form einer Adhäsions-Folie ausgebildete Adhesiv-Schicht 3 wird dabei auf der Kontaktrolle 16 aufgerollt und kann anschließend entsorgt werden. Der rotierenden Kontaktrolle 16 wird dazu eine Linearbewegung überlagert, d. h., sie wird mittels eines Linearantriebs 17 über den Trägerwafer 2 bewegt. Die Drehrichtung der Kontaktrolle 16 verläuft dabei entgegengesetzt zur Bewegungsrichtung über dem Trägerwafer 2, so dass durch diese überlagerten Dreh- und Linearbewegungen die Adhäsions-Folie 3 abgezogen und auf der Kontaktrolle 16 aufgewickelt wird.

## Patentansprüche

1. Debondierstation zum Trennen von miteinander mittels einer Adhesiv-Schicht zu Waferstacks verbundenen Systemwafern und Trägerwafern, **dadurch gekennzeichnet**, **dass** die Debondierstation (6) zum automatischen Trennen der Waferstacks (1) eine Trennstation (12) aufweist, welcher eine Waferstack- Aufbewahrungsstation (7), eine Systemwafer- Aufnahmestation (8) und eine Trägerwafer- Aufnahmestation (9) zugeordnet ist, dass ein Roboter (10) zur Entnahme der zu trennenden Waferstacks (1) aus der Waferstack- Aufbewahrungsstation (7) vorhanden ist, welcher die Waferstacks (1) einer Heizvorrichtung (13) zuführt, mittels der durch Erwärmung der Waferstacks (1) die Adhäsionskraft der Adhesiv-Schicht (3) zumindest soweit aufgehoben wird, dass ein am Roboter (10) befindlicher Endeffektor (14) den Systemwafer (4) vom Trägerwafer (2) lösen und in der zugeordneten Systemwafer- Aufnahmestation (7) ablegen kann, und dass eine Aufbereitungsvorrichtung (15). zum Behandeln der Trägerwafer (2) vorgesehen ist, derart, dass am Trägerwafer (2) die Adhesiv-Schicht (3) rückstandfrei entfernt und dieser in der Trägerwafer- Aufnahmestation (9) abgelegt werden kann.

2. Debondierstation nach Anspruch 1, **dadurch gekennzeichnet, dass** die Waferstack- Aufbewahrungsstation (7), die Systemwafer- Aufnahmestation (8) und die Trägerwafer- Aufnahmestation (9) als Kassettenstationen (7, 8, 9) ausgeführt sind.

3. Debondierstation nach Anspruch 1, **dadurch ge-kennzeichnet, dass** der Roboter (10) als mehrachsiger Handhabungsautomat ausgebildet ist.

4. Debondierstation nach Anspruch 1, **dadurch gekennzeichnet, dass** die Aufnahmevorrichtung in der Heizvorrichtung (13) und der Endeffektor (14) als Vakuumchucks ausgebildet sind.

5. Debondierstation nach Anspruch 1, **dadurch gekennzeichnet, dass** die Adhesiv-Schicht (3) als zweiseitig klebende Adhäsionsfolie ausgebildet ist.

6. Debondierstation nach Anspruch 1, **dadurch gekennzeichnet, dass** die Aufbereitungsvorrichtung (15) als Folienabziehvorrichtung ausgebildet ist.

7. Debondierstation nach Anspruch 1 oder 6, **dadurch gekennzeichnet, dass** die Folienabziehvorrichtung (15) über eine Kontaktrolle (16) verfügt, welche mit dem Trägerwafer (2) rotierend in Kontakt bringbar ist, wobei der rotierenden Kontaktrolle (16) eine Linearbewegung überlagerbar ist.

8. Debondierstation nach Anspruch 7, **dadurch gekennzeichnet, dass** die Rotationsrichtung der Kontaktrolle (16) und die Richtung der Linearbewegung gegenläufig sind.

9. Debondierstation nach einem der vorstehenden Ansprüche, **dadurch gekennzeichnet, dass** die Linearbewegung durch einen Linearantrieb (17) realisiert wird.
